# EUROPÄISCHE PATENTSCHRIFT

(11) **EP 2 589 273 B1**
(45) Veröffentlichungstag und Bekanntmachung des Hinweises auf die Patenterteilung: **27.12.2017**
(21) Anmeldenummer: 11743979.4
(22) Anmeldetag: 29.06.2011
(51) Int. Cl.: H05K 5/02, H05K 5/00

(54) **GEHÄUSE FÜR EINE ELEKTRONISCHE SCHALTUNG**
HOUSING FOR AN ELECTRONIC CIRCUIT
BOÎTIER POUR UN CIRCUIT ÉLECTRONIQUE

(30) Priorität: 11.10.2010 DE 102010042254; 30.06.2010 DE 102010030728
(43) Veröffentlichungstag der Anmeldung: 08.05.2013
(73) Patentinhaber: IFM Electronic GmbH, 45128 Essen (DE)
(72) Erfinder: WIEßNETH, Ernst, 86653 Monheim (DE)
(86) Internationale Anmeldenummer: PCT/EP2011/060918
(87) Internationale Veröffentlichungsnummer: WO 2012/001049

(56) Entgegenhaltungen:
- EP-A1- 0 484 288
- EP-A1- 1 527 956
- DE-A1-102006 053 114

## Beschreibung

Die Erfindung betrifft ein Gehäuse für eine elektronische Schaltung mit einem Druckausgleichselement auf einer Innenseite eines Gehäuseteils nach Gattung des unabhängigen Anspruchs.

Gehäuse für elektrische Schaltungen sind im Stand der Technik hinlänglich bekannt. Insbesondere werden im Kraftfahrzeugbereich elektronische Steuerschaltungen mit Hilfe eines Steuergeräte-Gehäuses geschützt. Diese Steuergeräte werden insbesondere im Motorraum eingesetzt und sind dort erheblichen Temperaturschwankungen ausgesetzt, die zu größeren Druckschwankungen im Inneren des Gehäuses führen können. Zum Ausgleich dieser Druckschwankungen können in einem einfachen Fall lediglich Bohrungen oder Öffnungen vorgesehen sein, über die sich die Druckunterschiede ausgleichen können. Nachteilig bei diesen Lösungen ist, dass über eine bloße Öffnung auch Wasser direkt in das Gehäuse dringen kann und dort Schäden verursacht. Um ein direktes Eindringen von Wasser ins Gehäuse zu verhindern, sind aus dem Stand der Technik so genannte semipermeable Membranen bekannt, die über eine Entlüftungsöffnung angeordnet Luft und auch Wasserdampf nach außen und innen über die Membran passieren lassen jedoch Wasser in flüssiger Form nicht.

Aus der EP 0 484 288 A1 ist ein Gehäuse für eine elektronische Schaltung bekannt, bei dem eine Gehäuseentlüftung über Verschraubungsbohrungen einer Steckerleiste erfolgt. Die Bohrung ist als Sackloch ausgeführt und weist mehrere radial angeordnete Einschnitte auf, die sich von außen bis ins Gehäuseinnere erstrecken. Im Gehäuseinneren ist am Ende dieser Einschnitte ein Druckausgleichelement angeordnet.

Aus der EP 1 527 956 A1 ist ein Gehäuse bekannt, bei dem die Entlüftung über eine Ventilationsöffnung erfolgt, die sich nach außen im Durchmesser vergrößert, wobei am Ende der Öffnung ein Druckausgleichselement angeordnet ist.

Die DE 10 2006 053 114 A1 offenbart ein Druckausgleichselement, das an einem seitlichen Rand eines Steckerverbindungselement angeordnet und mit einer Schutzkappe abgedeckt ist.

Aus der DE 41 40 487 A1 ist bereits ein Steuergerät bzw. Schaltgerät bekannt, bei dem in einer Ausnehmung einer Steckerleiste ein Druckausgleichselement in den Gehäusekörper eingespritzt ist. Die Entlüftung erfolgt hierbei über mehrere voneinander abgesetzte Bohrungen nach außen.

Ferner ist aus der DE 10 2007 035 094 A1 ein Gehäuse für eine elektrische Schaltung bekannt, das eine elektrische Steck-Anschlussvorrichtung und ein Druckausgleichelement aufweist, das mittels eines Schutzelements bzw. einer Abdeckhaube abgedeckt ist. Hierbei ist mindestens eine Druckausgleichsöffnung der Schutzkappe in Richtung einer Steck-Anschlussvorrichtung ausgerichtet.

Aufgabe der Erfindung ist es, die Effizienz der Entlüftung über das Druckausgleichselement zu verbessern.

Die Aufgabe wird in vorteilhafter Weise durch die erfindungsgemäße Vorrichtung des unabhängigen Anspruchs gelöst. Hierzu ist ein Gehäuse für eine elektronische Schaltung vorgesehen, bei dem ein Teil des Gehäuses als Stecker-Gehäuseteil mit einer elektrischen Steck-Anschlussvorrichtung ausgebildet ist. Das Druckausgleichselement bestehend aus mindestens einer semipermeablen Membran ist auf einer Innenseite des Stecker-Gehäuseteils unterhalb eines Entlüftungskanals angeordnet. Auf der Innenseite des Stecker-Gehäuseteils ist zur mechanischen Abgrenzung eines Aufnahmebereichs für das Druckausgleichselement ein Steg angeformt. Das Druckausgleichselement ist in diesem Aufnahmebereich angeordnet und mit der Innenseite bzw. einem Klebebereich des Stecker-Gehäuseteils verklebt. Innerhalb des Aufnahmebereichs ist oberhalb vom Druckausgleichselement zunächst eine Entlüftungsausnehmung mit einem ersten Querschnitt und nachfolgend ein erster Entlüftungskanal mit einem zweiten kleineren Querschnitt angeordnet. Der erste Entlüftungskanal mündet in einen zweiten Entlüftungskanal, der im Wesentlichen senkrecht zum ersten Entlüftungskanal geführt ist. Auf der Außenseite des Stecker-Gehäuseteils ist ein Gehäusefortsatz ausgebildet, innerhalb dessen sich der zweite Entlüftungskanal erstreckt. Der Entlüftungskanal durchbricht den Gehäusefortsatz an seinen beiden axialen Enden und bildet dort jeweils eine Öffnung nach außen.

Das erfindungsgemäße Vorgehen hat gegenüber dem bisher Bekannten den Vorteil, dass zum einen durch die stegförmige Abgrenzung des Aufnahmebereichs im Inneren des Gehäuses ein eindeutiger und geschützter Aufnahmebereich für das Druckausgleichselement geschaffen wird. Im Weiteren sind die Entlüftungskanäle so angeordnet, dass sich eine besonders vorteilhafte Entlüftungswirkung ergibt. Beispielsweise ergeben sich durch die senkrechte Anordnung der ersten und zweiten Entlüftungskanäle besondere Strömungsverläufe, die bereits bei leichten Luftströmungen durch den zweiten Entlüftungskanal einen Ansaugluftstrom im ersten Entlüftungskanal ausbilden.

Durch die in den abhängigen Ansprüchen aufgeführten Maßnahmen sind vorteilhafte Weiterbildungen und Verbesserung der im unabhängigen Anspruch angegebenen Erfindung möglich.

Bevorzugt ist der Gehäusefortsatz auf der Außenseite des Stecker-Gehäuseteils so angeordnet, dass er nicht auf einer Mitten-Symmetrieachse der Steck-Anschlussvorrichtung liegt. Dieses Vorgehen hat den besonderen Vorteil, dass sich durch diese exponierte Lage des Entlüftungskanals günstigere Strömungsverhältnisse am Entlüftungskanal einstellen und so die Entlüftung begünstigen.

Besonders Vorteilhaft ist es, wenn die axialen Achsen der Entlüftungskanäle außerhalb der Zentrumsachsen bzw. Achsenmitten der jeweils nachfolgenden Entlüftungsausnehmung bzw. Entlüftungskanals liegen. Nachfolgend wird die Erfindung anhand von Ausführungsbeispielen unter Bezugnahme auf die Zeichnungen näher erläutert.

Es zeigen schematisch:
Figur 1 einen Ausschnitt eines erfindungsgemäßen Gehäuses,
Figur 2 einen Querschnitt durch ein erfindungsgemäßes Gehäuse,
Figur 3 einen perspektivischen Querschnitt.

In der nachfolgenden Beschreibung der bevorzugten Ausführungsformen bezeichnen gleiche Bezugszeichen gleiche oder vergleichbare Komponenten.

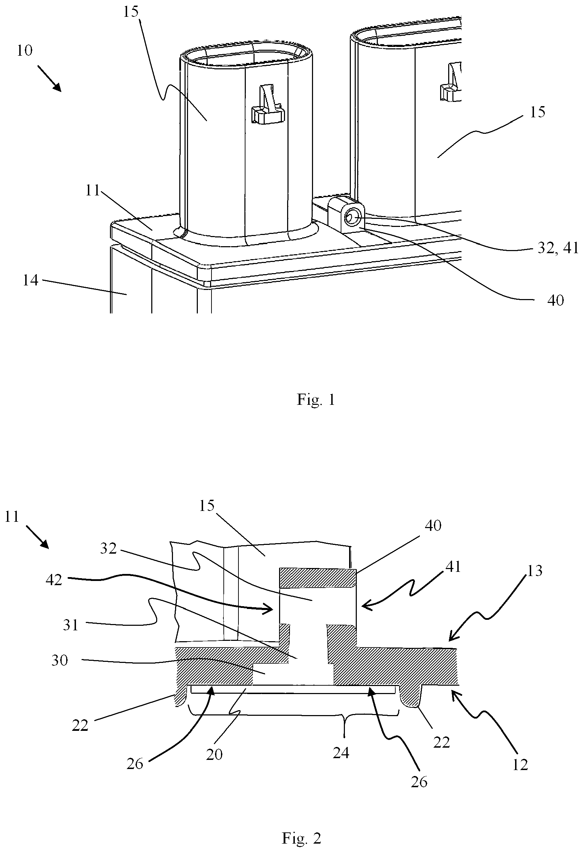

Figur 1 zeigt eine perspektivische Ansicht eines erfindungsgemäßen Gehäuses 10. Im oberen Bereich ist ein Stecker-Gehäuseteil 11 mit zwei angedeuteten Steck-Anschlussvorrichtungen 15 gezeigt. Mittig zwischen diesen beiden Steck-Anschlussvorrichtungen 15 ist etwas versetzt von der Mitten-Symmetrieachse der Anschlussvorrichtungen 15 ein Gehäusefortsatz 40 mit einem Entlüftungskanal 32 gezeigt. Unterhalb des Stecker-Gehäuseteils 11 ist ein Grundgehäuse 14 angedeutet, dass zusammen mit dem Stecker-Gehäuseteil 11 ein gemeinsames Gehäuse 10 bildet.

Die gegenüber den Steck-Anschlussvorrichtungen 15 versetzte Anordnung des Gehäusefortsatzes 40 hat den Vorteil, dass insbesondere in engen Einbausituationen das Druckausgleichselement und der Gehäusefortsatz 40 aus dem engen Steckerbereich herausgenommen werden kann. Dies erlaubt ggf. eine Vergrößerung des Druckausgleichselements und der Entlüftungskanäle und verbessert somit die Entlüftung.

Selbstverständlich ist je nach Anwendungsfall auch eine symmetrische Anordnung des Gehäusefortsatzes denkbar.

In Figur 2 ist ein Querschnitt durch das erfindungsgemäße Stecker-Gehäuseteil 11 gemäß Figur 1 entlang des zweiten Entlüftungskanals 32 bzw. Gehäusefortsatzes 40 gezeigt. Die Schnittfläche ist schraffiert dargestellt, wobei im Hintergrund eine Steck-Anschlussvorrichtung 15 angedeutet ist. Auf der Innenseite 12 des Stecker-Gehäuseteils 11 ist ein umlaufender Steg 22 angeformt, der einen Aufnahmebereich 24 für ein Druckausgleichselement 20 umgrenzt. Das Druckausgleichselement 20 ist innerhalb des Stegbereiches im Aufnahmebereich 24 mit der Innenfläche bzw. Innenseite 12 des Stecker-Gehäuseteils 11 verklebt. Innerhalb des Aufnahmebereichs 24 ist oberhalb des Druckausgleichselements 20 eine Ausnehmung 30 ausgebildet, die sich im Wesentlichen im Zentrum des Aufnahmebereichs erstreckt. Der Ausnehmung 30 nachfolgend schließt sich in Richtung der Außenseite 13 ein erster Entlüftungskanal 31 an, der anschließend in einem dazu senkrecht verlaufenden zweiten Entlüftungskanal 32 mündet. Der erste Entlüftungskanal 31 ist mit seiner Längsachse etwas außerhalb des Zentrums der Ausnehmung 30 angeordnet. Der zweite Entlüftungskanal 32 befindet sich in einem an dem Stecker-Gehäuseteil 11 angeformten Gehäusefortsatz 40, der sich oberhalb der Ebene der Außenseite 13 nach außen erstreckt. Der zweite Entlüftungskanal 32 ist im Wesentlichen mittig in diesem Gehäusefortsatz 40 geführt, so dass die Unterseite des zweiten Entlüftungskanal 32 ein wenig oberhalb der Außenseite 13 angeordnet ist bzw. nach außen geführt ist. Der zweite Entlüftungskanal 32 durchbricht den Gehäusefortsatz 40 an zwei Seiten und bildet dort eine erste Öffnung 41 und eine zweite Öffnung 42.

Diese versetzte bzw. dezentrierte Anordnung der Entlüftungskanäle zeigt, hat den Vorteil, dass die Lage des Gehäusefortsatzes 40 auf der Außenseite 13 in gewissen Grenzen unabhängig von der Lage des Druckausgleichselements festgelegt werden kann. Selbstverständlich ist auch eine symmetrische bzw. zentrische Anordnung der Entlüftungskanäle denkbar

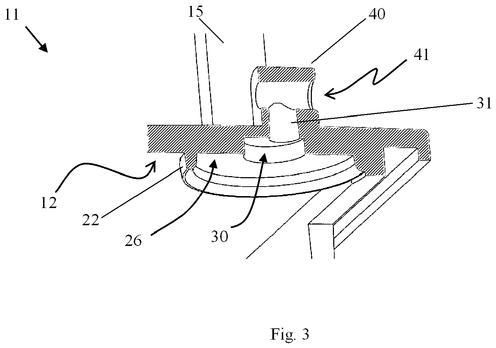

Die Figur 3 zeigt eine perspektivische Ansicht des Querschnitts gemäß Figur 2 mit Blick auf die Innenseite 12 des Stecker-Gehäuseteils 11. Deutlich ist die ringförmige Ausbildung des umlaufenden Stegs 22 zu erkennen, der die Aufnahmefläche 24 für das Druckausgleichselement 20 umgrenzt. In Figur 3 ist das Druckausgleichselement 20 nicht eingezeichnet. Dargestellt sind die Klebefläche 26 und die Entlüftungsausnehmung 30 auf der Innenseite 12.

Das erfindungsgemäße Gehäuse hat den Vorteil, dass durch den umlaufenden Steg eine eindeutige Position für das Druckausgleichselements bei der Montage gekennzeichnet und abgegrenzt ist. Dieser Steg hat insbesondere auch den Vorteil das Klebemittel exakt und ohne Beeinträchtigung der Umgebung außerhalb des Druckausgleichselements im Bereich der Klebefläche 26 aufgetragen werden können. Zudem bietet der Steg für das Druckausgleichselements einen seitlichen mechanischen Schutz. Die Klebefläche 26 ist in ihrer Dimensionierung vorzugsweise einem am Druckausgleichselement vorgesehenen Klebebereich angepasst.

Im Weiteren ist durch die Gestaltung der Entlüftungskanäle ein direkter mechanischer Angriff auf das Druckausgleichselement 20 von außen vorteilhaft verhindert. Insbesondere ist es von Vorteil, direkt oberhalb des Druckausgleichselements einen größeren Luftaustauschbereich durch die erste Ausnehmung 30 bereitzustellen, wobei im Weiteren insbesondere für die Bereitstellung eines gewissen Düseneffekts diese Ausnehmung zu einem ersten Entlüftungskanal 1 verjüngt wird. Der Düseneffekt wird insbesondere dadurch hervorgehoben, dass der zweite Entlüftungskanal 32 senkrecht zum ersten Entlüftungskanal 31 geführt ist. Des Weiteren ist es von Vorteil, den zweiten Entlüftungskanal innerhalb des Gehäusefortsatzes 40 so zu führen, dass die beiden Öffnungen des zweiten Entlüftungskanals mit einem Abstand zur Außenfläche 13 nach außen geführt sind. Die Ausbildung des Gehäusefortsatzes 40 am Stecker-Gehäuseteil 11 hat ferner den Vorteil, dass der Gehäusefortsatz 40 durch die Steck-Anschlussvorrichtung 15 in gewissen Grenzen vor einer mechanischen Beschädigung geschützt ist, darüber hinaus stört diese Positionierung auch nicht bei einer Befestigung des Gehäuses.

Selbstverständlich sind auch andere Dimensionierungen oder Ausrichtungen der Entlüftungskanäle denkbar. Insbesondere ist es auch denkbar, die Entlüftungskanäle jeweils zentrisch anzuordnen bzw. auch mittig nach außen zu führen.

Das Druckausgleichselement ist bevorzugt als semipermeable Membran ausgebildet durch die Luft und Wasserdampf jedoch kein Wasser im flüssigen Zustand dringen kann. In einer weiteren Ausgestaltung kann es zudem vorgesehen sein, dass das Druckausgleichselement aus mehreren Membranschichten und/oder zusätzlichen Stützschichten oder Stützkonstruktionen ausgebildet ist.

Bevorzugt ist das Gehäuse mit Hilfe eines Spritzgussverfahrens und vorzugsweise in Kunststoff gefertigt. Denkbar sind jedoch auch Ausführungen aus Metall.

Vorzugsweise sind die Entlüftungskanäle und ggf. auch die Ausnehmungen konisch bzw. angeschrägt geformt, um insbesondere im Spritzgussverfahren die Gehäuseherstellung zu vereinfachen. Durch eine derartige Formung kann beispielsweise eine Trennung des Spritzwerkzeugs vom Spritzgut erleichtert werden.

### Bezugszeichenliste

10 Gehäuse
11 Stecker-Gehäuseteil
12 Innenseite
13 Außenseite
14 Grundgehäuse
15 Steckanschlussvorrichtung
20 Druckausgleichselement
22 Steg
24 Aufnahmebereich
26 Klebebereich
30 Ausnehmung
31 erster Entlüftungskanal
32 zweiter Entlüftungskanal
40 Gehäusefortsatz
41, 42 Öffnung

## Patentansprüche

1. Gehäuse (1) für eine elektronische Schaltung, bei dem ein Teil des Gehäuses als Stecker-Gehäuseteil (11) mit einer elektrischen Steck-Anschlussvorrichtung (15) ausgebildet ist,
mit einem Druckausgleichselement (20) bestehend aus mindestens einer semipermeablen Membran, das auf einer Innenseite (12) des Stecker-Gehäuseteils (11) unterhalb eines Entlüftungskanals (31) angeordnet ist,
wobei auf der Innenseite (12) des Stecker-Gehäuseteils (11) ein Steg (22) angeformt ist, der einen Aufnahmebereich (24) für das Druckausgleichselement (20) umgrenzt,
**dadurch gekennzeichnet,**
**dass** das Druckausgleichselement (20) in diesem Aufnahmebereich (24) angeordnet und mit der Innenseite (12) des Stecker-Gehäuseteils (11) verklebt ist,
wobei das Stecker-Gehäuseteil (11) innerhalb des Aufnahmebereichs (24) ausgehend vom Druckausgleichselement (20) zunächst eine Ausnehmung (30) mit einem ersten Querschnitt und nachfolgend einen ersten Entlüftungskanal (31) mit einem zweiten kleineren Querschnitt aufweist,
wobei der erste Entlüftungskanal (31) in einen im Wesentlichen senkrecht dazu verlaufenden zweiten Entlüftungskanal (32) mündet,
und **dass** an dem Stecker-Gehäuseteil (11) ein Gehäusefortsatz (40) angeformt ist, der sich oberhalb einer Ebene einer Außenseite (13) des Stecker-Gehäuseteils (11) nach außen erstreckt, wobei der zweite Entlüftungskanal (32) innerhalb dieses Gehäusefortsatzes (40) geführt ist
und an beiden axialen Enden eine Öffnung (41, 42) nach außen aufweist.

2. Gehäuse nach einem der vorhergehenden Ansprüche, bei dem der Gehäusefortsatz (40) auf der Außenseite (13) des Stecker-Gehäuseteils (11) so angeordnet ist, dass er nicht auf einer Mitten-Symmetrieachse der Steck-Anschlussvorrichtung liegt.

3. Gehäuse nach einem der vorhergehenden Ansprüche, bei dem eine axiale Achse des ersten Entlüftungskanals (31) außerhalb der Zentrumsachse der Ausnehmung (30) liegt.

## Claims

1. Housing (1) for an electronic circuit, in which a portion of the housing is in the form of a plug housing part (11) with an electrical plug-type connection apparatus (15),
having a pressure compensation element (20) comprising at least one semipermeable diaphragm which is arranged on an inner side (12) of the plug housing part (11) below a venting channel (31),
wherein a web (22) which delimits a receiving region (24) for the pressure compensation element (20) is integrally formed on the inner side (12) of the plug housing part (11),
**characterized**
**in that** the pressure compensation element (20) is arranged in this receiving region (24) and is adhesively bonded to the inner side (12) of the plug housing part (11),
wherein the plug housing part (11), within the receiving region (24), starting from the pressure compensation element (20), initially has a recess (30) with a first cross section and then a first venting channel (31) with a second smaller cross section,
wherein the first venting channel (31) issues into a second venting channel (32) which runs substantially perpendicular to the said first venting channel,
and **in that** a housing projection (40) is integrally formed on the plug housing part (11), the said housing projection extending outward above a plane of an outer side (13) of the plug housing part (11), wherein the second venting channel (32) is routed within this housing projection (40)
and has an opening (41, 42) to the outside at both axial ends.

2. Housing according to one of the preceding claims, in which the housing projection (40) is arranged on the outer side (13) of the plug housing part (11) such that it does not lie on a central axis of symmetry of the plug-type connection apparatus.

3. Housing according to either of the preceding claims, in which an axial axis of the first venting channel (31) lies outside the central axis of the recess (30).

## Revendications

1. Boîtier (1) pour un circuit électronique, dans lequel une partie du boîtier est réalisée sous forme de partie de boîtier de connecteur (11) avec un dispositif électrique de raccordement par enfichage (15),
avec un élément d'équilibrage de la pression (20) constitué d'au moins une membrane semi-perméable disposée sur un côté intérieur (12) de la partie de boîtier de connecteur (11) en dessous d'un canal d'aération (31),
une nervure (22) étant façonnée du côté intérieur (12) de la partie de boîtier de connecteur (11), laquelle délimite une zone de réception (24) pour l'élément d'équilibrage de la pression (20),
**caractérisé en ce que**
l'élément d'équilibrage de la pression (20) est disposé dans cette zone de réception (24) et est collé au côté intérieur (12) de la partie de boîtier de connecteur (11),
la partie de boîtier de connecteur (11) présentant à l'intérieur de la zone de réception (24) à partir de l'élément d'équilibrage de la pression (20), tout d'abord un évidement (30) avec une première section transversale, puis un premier canal d'aération (31) avec une deuxième section transversale plus petite,
le premier canal d'aération (31) débouchant dans un deuxième canal d'aération (32) s'étendant essentiellement perpendiculairement à celui-ci,
et **en ce qu'**un prolongement de boîtier (40) est façonné au niveau de la partie de boîtier de connecteur (11), lequel s'étend vers l'extérieur au-dessus d'un plan d'un côté extérieur (13) de la partie de boîtier de connecteur (11), le deuxième canal d'aération (32) étant guidé à l'intérieur de ce prolongement de boîtier (40),
et présentant aux deux extrémités axiales une ouverture (41, 42) vers l'extérieur.

2. Boîtier selon l'une quelconque des revendications précédentes, dans lequel le prolongement de boîtier (40) est disposé sur le côté extérieur (13) de la partie de boîtier de connecteur (11) de manière à ne pas se trouver sur un axe de symétrie médian du dispositif de raccordement par enfichage.

3. Boîtier selon l'une quelconque des revendications précédentes, dans lequel un axe axial du premier canal d'aération (31) est situé à l'extérieur de l'axe central de l'évidement (30).
